Europäisches Patentamt

European Patent Office

Office européen des brevets

(11) Numéro de publication: **0 262 019**
**A1**

## (12) DEMANDE DE BREVET EUROPEEN

(21) Numéro de dépôt: **87402006.8**

(22) Date de dépôt: **08.09.87**

(51) Int. Cl.⁴: **G 01 R 31/00**
G 01 R 31/28, G 01 R 15/02

(30) Priorité: **12.09.86 FR 8612819**

(43) Date de publication de la demande:
**30.03.88 Bulletin 88/13**

(84) Etats contractants désignés:
**AT BE CH DE ES GB IT LI NL**

(71) Demandeur: **THOMSON-CSF**
**173, Boulevard Haussmann**
**F-75379 Paris Cédex 08 (FR)**

(72) Inventeur: **Pozzo, Claude**
**THOMSON-CSF SCPI 19, avenue de Messine**
**F-75008 Paris (FR)**

(74) Mandataire: **Grynwald, Albert et al**
**THOMSON-CSF SCPI 19, avenue de Messine**
**F-75008 Paris (FR)**

(54) **Dispositif de test pour alimentation à très haute tension.**

(57) Dispositif de test pour alimentation continue de très haute tension, d'au moins 1 KV et de puissance limitée, au plus 1 KW.

Il comporte un tube à vide (20) et un générateur (27) appliquant sur la grille (26) du tube un signal de valeur réglable représentant la charge de l'alimentation THT (13).

EP 0 262 019 A1

**Description**

DISPOSITIF DE TEST POUR ALIMENTATION A TRES HAUTE TENSION

L'invention est relative à un dispositif de test pour alimentations à très haute tension, d'au moins un Kilovolt (KV) et de puissance limitée, 1 KW au maximum.

Les alimentations à très haute tension (THT) et de puissance réduite sont utilisées dans des domaines très variés. On citera à titre d'exemples la visualisation (tube à masque et tube à pénétration), la microscopie électronique, et les imprimantes à jets d'encre.

Chaque alimentation doit présenter des caractéristiques de tension et de courant de sortie qui dépendent de l'utilisation envisagée. Le fabricant ou le futur utilisateur doivent, avant de brancher l'alimentation aux bornes d'un appareil (souvent onéreux) faisant appel à une très haute tension, vérifier les caractéristiques de l'alimentation-notamment la tension et l'intensité du courant de sortie-et, le cas échéant, vérifier le bon fonctionnement de certains organes tels que la boucle de régulation.

Jusqu'à présent ces vérifications s'effectuent à l'aide d'un dispositif de test constitué de résistances électriques simulant la charge du générateur THT. Mais les résistances pouvant supporter les très hautes tensions sont d'un prix élevé ce qui est d'autant plus gênant qu'il faut, pour simuler les diverses charges possibles, disposer d'un nombre important de résistances de ce type.

En outre, pour la simulation des diverses conditions d'utilisation, il serait souhaitable de disposer d'un interrupteur permettant de brancher et de débrancher rapidement la charge. Mais les interrupteurs pouvant supporter les très hautes tensions sont aussi très onéreux et, surtout, ils ne peuvent pas être actionnés rapidement.

L'invention remédie aux inconvénients mentionnés ci-dessus.

Elle est caractérisée en ce que le dispositif de test, comporte, pour simuler la charge de l'alimentation continue très haute tension, un tube à vide THT, et un générateur appliquant sur l'électrode de commande du tube (la grille dans le cas d'une triode) un signal réglable en fonction de la charge à simuler.

Il n'est ainsi pas nécessaire de disposer d'un jeu important de résistances. En outre, le potentiel sur l'électrode de commande peut être établi ou supprimé rapidement, ce qui simule un interrupteur rapide.

Ou aurait, certes, pu envisager d'utiliser des composants à état solide tels que des transistors pour simuler la charge. Mais de tels composants ne supportant pas les très hautes tensions il aurait fallu en prévoir plusieurs en série, ce ui pose, pour la commande, des problèmes d'isolation et aussi de simultanéité. Ainsi, de façon surprenante, l'invention va à l'encontre d'une tendance générale de la technique depuis plusieurs dizaines d'années qui est de ne plus faire appel aux tubes à vide, et d'utiliser systématiquement des composants à état solide.

Si le débit en courant d'un tube est insuffisant on peut disposer plusieurs tubes en parallèle.

Dans le mode de réalisation préféré, le dispositif de test comporte en série avec le tube ou avec chaque tube, une résistance de mesure utilisable, d'une part, pour la mesure du débit dans la charge et, d'autre part, pour la régulation du débit dans chaque tube (quand on prévoit plusieurs tubes) afin que le courant soit réparti équitablement entre les divers tubes.

Pour les très hautes tensions de valeurs très élevées on peut envisager l'utilisation de plusieurs tubes en série.

Dans une réalisation le dispositif de test comporte un interrupteur de sécurité du type à contacts et un dispositif de détection d'au moins une condition de sécurité, cet interrupteur n'étant fermé, pour faire débiter l'alimentation THT dans la charge du dispositif de test, que si la (ou les) condition (s) de sécurité est satisfaite. La condition de sécurité est, par exemple, l'une ou plusieurs des suivantes : le signe du potentiel appliqué à l'entrée du dispositif de test, la valeur de ce potentiel qui doit être comprise entre des limites prédéterminées, dans un exemple entre 1 KV et 27 KV, et la température ambiante.

En outre il est préférable que le dispositif de test comporte un moyen de temporisation pour que l'interrupteur de sécurité ne se ferme qu'après un intervalle de temps prédéterminé suivant le début de l'alimentation en énergie du dispositif, ce temps prédéterminé correspondant à une durée suffisante de chauffage du tube à vide.

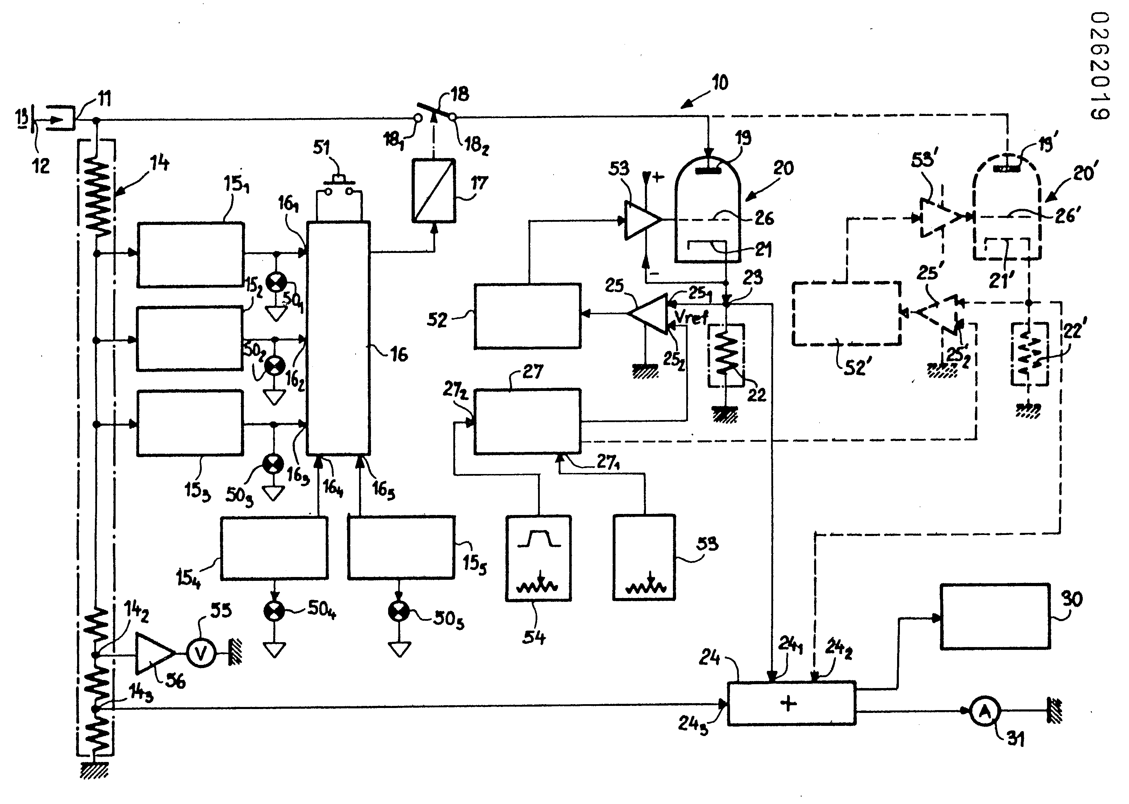

D'autres caractéristiques et avantages de l'invention apparaîtront avec la description de certains de ses modes de réalisation, celle-ci étant effectuée en se référant au dessin ci-annexé sur lequel la figure unique est un schéma d'un dispositif de test et d'une alimentation très haute tension.

Le dispositif de test 10 comporte une entrée 11 destinée à être connectée à la sortie 12 à haut potentiel d'une alimentation très haute tension 13, d'au moins un Kilovolt.

Immédiatement à l'aval de l'entrée 11 est connecté un pont diviseur 14 à fort coefficient de réduction et forte impédance (1000 M dans l'exemple) suivi de détecteurs $15_1$ à $15_5$, alimentant un dispositif de commande 16 agissant, en fonction du signal reçu des détecteurs 15, sur la bobine 17 d'un relais 18 à contacts du type à très haute tension, c'est-à-dire à grande distance entre les contacts $18_1$ (relié à l'entrée) et $18_2$ (relié au reste du circuit du dispositif 10).

Le détecteur $15_1$ détecte la valeur (amplitude) minimum du potentiel à l'entrée 11 et la compare à une valeur prédéterminée de 1 KV. Si cette valeur minimum dépasse 1 KV ce circuit $15_1$ fournit un signal d'autorisation sur une entrée correspondante $16_1$ du circuit de commande 16. Par ailleurs, si cette condition de minimum de potentiel est respectée une lampe témoin $50_1$ s'allume.

De façon analogue le détecteur $15_2$ détecte la

valeur maximum du potentiel à l'entrée 11, la compare à une valeur de 27 KV et délivre un signal d'autorisation sur une entrée $16_2$ du circuit 16 si ce potentiel est inférieur à la valeur de 27 KV. Dans ce cas une lampe témoin $50_2$ s'allume.

Le détecteur $15_3$ détecte le signe du potentiel à l'entrée 11, le compare à un signe prédéterminé et délivre sur une entrée $16_3$ du circuit 16 un signal d'autorisation si le signe est correct. Dans ce cas, une lampe témoin $50_3$ s'allume.

Le détecteur de température $15_4$, par exemple à thermistance, mesure la température de la charge, la compare à une valeur maximum et fournit un signal d'autorisation sur une entrée $16_4$ du circuit 16 si la température est inférieure au maximum. Une lampe témoin $50_4$ s'allume quand la température n'est pas prohibitive.

Le détecteur $15_5$ détecte l'instant de mise en circuit du dispositif 10, c'est-à-dire le début de l'alimentation en énergie électrique de ce dispositif, par exemple par sa connexion au réseau 220 V, 50 Hz. Le signal que délivre ce détecteur $15_5$ à une entrée $16_5$ du circuit 16 est, pendant une durée de trente secondes, un signal d'inhibition. A l'issue de cette durée de temporisation le signal sur l'entrée $16_5$ est un signal d'autorisation. A ce moment, une lampe témoin $50_5$ s'allume.

En outre le circuit 16 est relié à un interrupteur 51, par exemple du type à bouton poussoir, actionné par l'opérateur et le circuit 16 ne délivre un signal d'excitation de la bobine 17 que si, d'une part, l'opérateur agit sur l'interrupteur 51 et, d'autre part, toutes les entrées $16_1$ à $16_5$ reçoivent un signal d'autorisation. Ainsi l'interrupteur haute tension 18 ne se ferme que lorsqu'un certain nombre de conditions de sécurité sont satisfaites.

Le second contact $18_2$ de l'interrupteur 18-séparé par une grande distance du premier contact $18_1$ relié directement à l'entrée 11-est connecté à l'anode 19 d'une triode THT 20 qui constitue (avec la triode 20') l'élément principal du dispositif de test 10. La cathode 21 de la triode est reliée à la masse par l'intermédiaire d'une résistance de mesure 22.

Le point commun 23 à la résistance de mesure 22 et à la cathode 21 est relié, d'une part, à la première entrée $24_1$ d'un additionneur 24 et, d'autre part, à la première entrée $25_1$ d'un comparateur 25 dont la seconde entrée $25_2$ reçoit un signal de référence $V_{ref}$. La sortie du comparateur 25 est connectée à l'entrée d'un photocoupleur 52 dont la sortie agit sur un circuit 53 de commande de la grille 26 de la triode 20.

Le signal sur la seconde entrée $25_2$ du comparateur 25 est fourni par un générateur 27 de tension continue délivrant un potentiel de valeur réglable. Ce potentiel est soit continu soit sous forme d'impulsion (s). Dans le premier cas (potentiel continu) le générateur 27 reçoit sur une première entrée $27_1$ un signal de valeur réglable par l'utilisateur grâce à l'action de ce dernier sur un circuit $53_1$ de commande de courant continu. Dans le second cas : commande par impulsion (s) ou par créneau (x), le générateur 27 est commandé par un signal appliqué sur une seconde entrée $27_2$, ce signal étant fourni par un second circuit de commande 54 présentant également un organe réglable par l'utilisateur.

Dans l'exemple on prévoit une seconde triode 20' (représentée en traits interrompus) identique à la triode 20 et branchée en parallèle, c'est-à-dire que son anode 19' est reliée au contact $18_2$ et sa cathode 21' est reliée à la masse par l'intermédiaire d'une résistance de mesure 22'. Un comparateur 25' est également associé à la triode 20'. Le générateur 27 assure aussi la commande de la grille 26'. La borne de la résistance de mesure 22' opposée à la masse est reliée à une seconde entrée $24_2$ de l'additionneur 24.

La sortie de l'additionneur 24 est reliée à une sortie connectable à un dispositif de mesure 30. Cette sortie de l'additionneur est également reliée à un organe d'affichage 31.

Une borne $14_2$ du pont diviseur 14 est utilisée pour la connexion d'un organe 55, du type numérique, d'affichage de la haute tension. Cet organe 55 est relié à la borne $14_2$ par l'intermédiaire d'un amplificateur 56.

Une autre borne $14_3$ de ce pont 14 est connectée à une troisième entrée $24_3$ de l'additionneur 24. Cette dernière disposition permet de tenir compte de la consommation des résistances du pont 14 pour l'affichage du courant de sortie par les dispositifs 30 et 31. Cette correction est surtout intéressante pour les faibles consommations des tubes 20 et 20', c'est-à-dire pour les fortes impédances simulées.

Le fonctionnement est le suivant :

Le générateur 27 est réglé pour délivrer un potentiel de valeur telle que l'impédance présentée par les tubes 20 et 20' en parallèle corresponde à celle souhaitée pour la charge de l'alimention THT 13.

Les dispositifs 30 et 31 indiquent le débit total de cette charge simulée.

Les comparateurs 25 et 25' permettent, avec le même potentiel de référence appliqué sur les entrées $25_2$ et $25'_2$, d'égaliser les débits des tubes 20 et 20', pour empêcher qu'un tube soit trop sollicité alors que l'autre ne l'est pas assez.

Les photocoupleurs 52 et 52' isolent les grilles 26 et 26' par rapport à la résistance de mesure correspondante 22, 22'. Ainsi il n'est pas tenu compte du courant des grilles pour la mesure du courant de charge.

Chaque circuit 53, 53' délivre un potentiel qui est soit positif, soit négatif. Dans la plupart des cas le potentiel sera négatif. Toutefois pour une alimentation à potentiel proche de la limite inférieure et pour les charges élevées, c'est-à-dire les faibles valeurs d'impédance, le potentiel de la grille sera faiblement positif.

## Revendications

1. Dispositif de test pour alimentation continue de très haute tension, d'au moins 1 Kilovolt, et de puissance limitée, au plus 1 Kilowatt, caractérisé en ce qu'il comporte un tube à vide (20, 20') et un générateur (27, 25, 53) appliquant sur l'électrode de commande (26, 26') de ce tube à vide un signal de valeur réglable représentant la charge de l'alimentation THT (13).

2. Dispositif selon la revendication 1 caractérisé en ce que le tube à vide est une triode (20, 20').

3. Dispositif selon la revendication 1 ou 2 caractérisé en ce qu'il comporte au moins deux tubes (20, 20') en parallèle.

4. Dispositif selon l'une quelconque des revendications 1 à 3 caractérisé en ce qu'il comporte au moins deux tubes en série.

5. Dispositif selon la revendication 3 ou 4 caractérisé en ce qu'à chaque tube (20, 20') est associé un moyen de régulation (22, 22', 25, 25') permettant d'équilibrer les débits dans chacun des tubes.

6. Dispositif selon la revendication 5 caractérisé en ce que le moyen de régulation comporte, pour chaque tube, une résistance de mesure (22, 22') en série avec ce tube et un comparateur (25, 25') destiné à comparer la tension aux bornes de cette résistance de mesure avec une valeur de consigne ($V_{ref}$), le signal de comparaison agissant sur l'électrode de commande (26, 26') du tube (20, 20').

7. Dispositif selon l'une quelconque des revendications précédentes caractérisé en ce qu'il comprend en série avec le tube (20, 20') une résistance de mesure (22, 22') et un moyen de mesure, (24, 30, 31) pour déterminer le débit dans le tube en fonction de la tension aux bornes de la résistance de mesure (22, 22').

8. Dispositif selon les revendications 6 et 7 caractérisé en ce que la même résistance de mesure (22, 22') est utilisée pour la mesure du débit et la régulation.

9. Dispositif selon l'une quelconque des revendications précédentes caractérisé en ce qu'il comporte un interrupteur (18) à contacts ($18_1$, $18_2$) pour établir la connexion entre la sortie de l'alimentation THT (13) et le dispositif de test (10) seulement quand certaines conditions de sécurité sont satisfaites.

10. Dispositif selon la revendication 9 caractérisé en ce que l'interrupteur (18) n'est fermé qu'après un temps déterminé suivant le début de l'alimentation en énergie de ce dispositif ce temps déterminé étant au moins égal au temps de chauffage du tube (20, 20').

11. Dispositif selon la revendication 9 ou 10 caractérisé en ce qu'il comporte un détecteur de signe du potentiel à son entrée (11) pour ne fermer l'interrupteur (18) que si le signe détecté correspond à un signe prédéterminé.

12. Dispositif selon la revendication 9, 10 ou 11, caractérisé en ce qu'il comprend un détecteur d'amplitude pour fermer l'interrupteur à contacts (18) seulement si l'amplitude du signal d'entrée est comprise entre des limites prédéterminées.

13. Dispositif selon l'une quelconque des revendications 9 à 12 caractérisé en ce que l'interrupteur (18) à contacts est ouvert quand la température ambiante dépasse une valeur déterminée.

14. Dispositif selon la revendication 6 caractérisé en ce qu'il comporte un moyen, tel qu'un photocoupleur (52), entre le comparateur (25) et l'électrode de commande (26) du tube (20), pour isoler le circuit de l'électrode de commande par rapport au circuit de mesure afin que le courant de commande du tube ne passe pas par la résistance de mesure (22, 22').

15. Dispositif selon la revendication 3 caractérisé en ce qu'il comprend un additionneur (24) pour additionner des signaux représentant l'intensité du courant circulant dans chaque tube (20, 20').

16. Dispositif selon la revendication 15 caractérisé en ce qu'il comporte un diviseur (14) de tension et en ce qu'un signal représentant l'intensité du courant traversant ce diviseur est appliqué sur une entrée ($24_3$) de l'additionneur (24).

17. Dispositif selon l'une quelconque des revendications précédentes caractérisé en ce qu'il comporte un générateur (27) permettant d'appliquer sur l'électrode de commande (26, 26') du tube à vide, à volonté un courant continu ou un courant impulsionnel.

0262019

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X,Y | US-A-3 383 589  (N.G. DUGAN)<br>* Colonne 1, ligne 50 - colonne 2, ligne 52; colonne 5, ligne 74 - colonne 6, ligne 30; colonne 6, lignes 65-69; figures 1,2 * | 1 | G 01 R  31/00<br>G 01 R  31/28<br>G 01 R  15/02 |
| A | | 2,3,7,9,15,17 | |
| | --- | | |
| Y | GB-A-2 090 441  (WESTINGHOUSE)<br>* Page 1, lignes 9-45; page 2, ligne 57 - ligne 81; page 3, lignes 16-98; figures 1,2 * | 1 | |
| A | | 4-9,14,15 | |
| | --- | | |
| A | US-A-3 361 954  (C.O. JORGENSEN)<br>* Colonne 2, ligne 62 - colonne 3, ligne 45; figure 1 * | 2 | |
| | --- | | |
| A | RADIO FERNSEHEN ELEKTRONIK; vol. 27, no. 10, octobre 1978, pages 629-631, Berlin, DE; E.A. FROMMHOLD: "Statisches Hochspannungs-Röhrenvoltmeter für Gleichspannungs- und Scheitelspannungsmessungen"Page 629, colonne 1, ligne 19 - colonne 3, ligne 4; figures 1-3 | 2 | DOMAINES TECHNIQUES RECHERCHES (Int. Cl.4)<br><br>G 01 R  31/00<br>G 01 R  15/00<br>G 01 R  19/00<br>G 05 F   1/00 |
| | --- | | |
| A | EP-A-0 171 563  (IBM)<br>* Page 4, ligne 18 - page 6, ligne 4; figure 1 * | 1,3,5-8 | |
| | --- | | |
| A | US-A-4 288 739  (NERCESSIAN)<br>* Colonne 2, ligne 53 - colonne 3, ligne 56; figure 2 *<br>---                    -/- | 6-8 | |

Le présent rapport a été établi pour toutes les revendications

| Lieu de la recherche | Date d'achèvement de la recherche | Examinateur |
|---|---|---|
| LA HAYE | 11-12-1987 | TRELEVEN C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-3 244 843  (SIEMENS)<br>* Page 5, ligne 6 - page 6, ligne 3; figures 1,2 *<br>--- | 6-8 | |
| A | GB-A-  649 374  (R.F. LAURENCE)<br>* Page 2, ligne 59 - page 3, ligne 6; revendications 7,9; figure 1 *<br>--- | 10 | |
| A | US-A-4 357 574  (TAKAMISAWA)<br>* Colonne 3, ligne 1 - colonne 4, ligne 28; colonne 5, ligne 33 - colonne 7, ligne 36; figures 1-3 *<br>--- | 9-10,12 -13 | |
| A | US-A-3 848 181  (J.O. HEBERT Jr.)<br>* Colonne 7, lignes 56-68; colonne 10, lignes 1-31; figures 3,7 *<br>--- | 1,5,11 | |
| O | IEEE CONFERENCE RECORD OF THE 1986 SEVENTEENTH POWER MODULATOR SYMPOSIUM, 23-25 juin 1986, Seattle US pages 126-129; D. DRAPER et al.: "High-speed, high-voltage shunt regulator"<br>* Page 127, colonne 1, lignes 1-17; page 128, colonne 1, lignes 1-11; figure 2 *<br>----- | 9,13,16 | **DOMAINES TECHNIQUES RECHERCHES (Int. Cl.4)** |

Le présent rapport a été établi pour toutes les revendications

| Lieu de la recherche | Date d'achèvement de la recherche | Examinateur |
|---|---|---|
| LA HAYE | 11-12-1987 | TRELEVEN C. |